# FASCICULE DE BREVET EUROPEEN

(11) **EP 0 583 201 B1**
(45) Date de publication et mention de la délivrance du brevet: **19.11.2003**
(21) Numéro de dépôt: 93402036.3
(22) Date de dépôt: 10.08.1993
(51) Int. Cl.: H01L 25/10, H01L 25/065

(54) **Module multi-puces à trois dimensions**
Dreidimensionaler Mehrchipmodul
Three-dimensional multichip module

(30) Priorité: 13.08.1992 FR 9210003
(43) Date de publication de la demande: 16.02.1994
(73) Titulaire: COMMISSARIAT A L'ENERGIE ATOMIQUE, 75015 Paris (FR)
(72) Inventeur: Massit, Claude, F-38330 Saint Ismier (FR); Nicolas, Gérard, F-38340 Voreppe (FR)
(74) Mandataire: Poulin, Gérard

(56) Documents cités:
- EP-A- 0 531 724
- WO-A-88/05251
- US-A- 5 019 943
- US-A- 5 128 831

## Description

La présente invention concerne un module multi-puces à trois dimensions. Un tel module trouve de nombreuses applications dans le domaine de la microconnectique appliquée, notamment, à l'association de circuits intégrés.

Dans toute la description qui va suivre, on comprendra par "circuit intégré" un boîtier de dimensions centimétriques comportant une ou plusieurs puces (appelées CHIP, en terme anglosaxon), qui assurent les fonctionnalités dudit circuit intégré. Chacune de ces puces est réalisée en un matériau semi-conducteur, tel que le silicium ou l'arséniure de gallium. A la surface de ces puces, sont formés les éléments nécessaires à son fonctionnement.

A la périphérie des puces, des plots permettent le raccordement desdites puces à des circuits d'interface avec l'extérieur ; au centre de ces puces, se trouvent des zones actives comportant une pluralité de composants électroniques, tels que des transistors, des résistances, des capacités, etc. Des circuits d'interconnexion sont réalisés sur lesdites puces afin de permettre la connexion des composants électroniques entre eux et avec les plots de raccordement de la puce.

De nos jours, l'augmentation de la complexité des systèmes informatiques est telle qu'il est nécessaire, pour la plupart des fabriquants de circuits intégrés, de réaliser un accroissement relatif du nombre de composants électroniques par unité de surface desdits circuits intégrés.

Il est possible, pour augmenter l'intégration des composants électroniques, de diminuer les géométries de chacun des composants constituant le circuit intégré en définissant des procédés submicroniques.

Cependant, une telle méthode se heurte à des limites physiques, à savoir la miniaturisation par la longueur d'onde des systèmes optiques d'insolation des résines.

Une autre méthode pour accroître le nombre de composants par unité de surface consiste à augmenter la surface élémentaire des puces. On comprend, bien évidemment, que cette augmentation de la taille des puces est un inconvénient en ce qui concerne la place nécessaire à l'intégration des circuits intégrés dans les systèmes informatiques et en ce qui concerne les rendements de fabrication.

Une autre méthode consiste à réaliser un module multi-puces.

Un mode de réalisation de ce module multi-puces, consiste en un module de technologie monolithique, connu sous le nom de WAFER SCALE INTEGRATION. Dans un tel module multi-puces, le circuit intégré est constitué par une tranche de silicium et les fonctionnalités du système sont obtenues par l'introduction d'éléments redondants permettant de remplacer des éléments défectueux.

Selon une autre technologie, à savoir la technologie hybride, les fonctions électroniques complexes sont réalisées directement sur une plaque de silicium servant de support d'interconnexion. Les composants actifs, à savoir les puces, peuvent être réalisé en Arséniure de gallium et sont reliés directement sur la plaque de silicium par des techniques, telles que le montage à fils (WIRE BONDING, en terme anglosaxon), le transfert automatique sur bande, etc.

Ces technologies hybride et monolithique sont décrites de façon plus précise dans l'article, intitulé "LE CHIP CARRIER, support universel de pastilles à haut niveau d'intégration", publié dans la revue ELECTRONIQUE INDUSTRIELLE, n° 31. Ces technologies hybride et monolithique proposent donc des modules multi-puces à deux dimensions qui permettent de meilleures performances et une plus grande capacités des systèmes.

Cependant, la surface des circuits intégrés reste souvent trop importante pour des systèmes informatiques de plus en plus puissants.

Aussi, une méthode consiste à utiliser la troisième dimension pour empiler les puces les unes sur les autres afin de diminuer la surface du circuit intégré et d'augmenter les performances en fréquence.

Dans un article intitulé "3D INTERCONNECTION FOR ULTRA-DENSE MULTICHIP MODULES", (Proceedings ECTC 1990, Las Vegas, p. 540-547) est présenté un module multi-puces tridimensionnel qui consiste en un assemblage par collage de plusieurs puces possédant leurs fils d'interconnexion entre les plots du silicium et un ruban de transfert automatique sur bande. Cet ensemble de puces est alors scié afin de réléver la section des fils d'interconnexion. La prise de contact électrique s'effectue sur la section des fils, par métallisation d'une ou plusieurs faces du cube constitué des différentes puces.

Un autre module multi-puces 3D est décrit dans le document, intitulé "HIGH DENSITY 3D PROCEEDING", écrit par John C. CARSON et Myles F. SUER, (WORKSHOP ON VLSI RECHARGING TECHNIC, Juin 1991, Villefranche/Mer), ainsi que dans l'article intitulé "3D IC PACKAGING MOVES CLOSER TO COMMERCIAL USE", écrit par J. Robert LINEBACK, dans la revue "ELECTRONIC WORLD NEWS" (Mai 1990). Ce module multi-puces 3D consiste en un ajout d'une métallurgie sur la passivation des plaquettes (WAFERS, en terme anglosaxon) afin de ramener des lignes d'interconnexion des plots des puces vers le bord de chacune desdites puces. La plaquette est ensuite sciée et les puces sont collées les unes aux autres. Sur un ou plusieurs côtés du cube réalisé par le collage des puces entre elles, est effectuée une métallurgie permettant de ramener tous les plots sur une face du cube afin qu'ils puissent être montés sur un substrat (c'est-à-dire très souvent sur une plaque de silicium) ou dans un boîtier.

De tels modules multi-puces remplissent effectivement l'objectif d'intégration maximale, mais ils présentent l'inconvénient d'être technologiquement très difficiles à réaliser. En outre, ces modules présentent des problèmes du point de vue dissipation thermique, du fait du confinement des circuits actifs. De plus, de tels modules ne sont adaptés que pour l'interconnexion d'un seul type de puces ; en effet, de tels modules conduisent à empiler le même circuit intégré dans la troisième dimension.

Un autre module multi-puces trois dimensions a été décrit dans le document intitulé "TEXAS INSTRUMENT DEMONSTRATIONS", dans la revue intitulée "AVIATION WEEK AND SPACE TECHNOLOGY" (Février 1992).

Cet article décrit, en effet, un module multi-puces 3D, c'est-à-dire un module de base volumique réalisé à partir de modules bidimensionnels de façon à interconnecter perpendiculairement, et à refroidir, tous les modules bidimensionnels. Un tel module multi-puces a pour inconvénient de nécessiter la réalisation d'un bloc usiné spécifique où des cartes viennent s'interconnecter perpendiculairement.

Le document WO-A-8 805 251 propose également un module multi-chip tridimensionnel. Cependant, l'assemblage de modules élémentaires sur le substrat de base s'effectuant orthogonalement, il est nécessaire :
- de prolonger le réseau d'interconnexion, situé sur la face supérieure des modules, sur un bord (tranche) de ce module, opération coûteuse et difficilement réalisable ;
- d'aligner avec grande précision tous les modules afin d'obtenir la planéité requise pour l'assemblage de ces modules sur le substrat de base.

Cet assemblage électrique se faisant sur toute la surface du substrat de base, il semble donc impossible de contrôler et, à fortiori de réparer, ces connexions.

Le brevet US-A-5 128 831 propose un autre type de module multi-chip. Cependant, l'assemblage de modules élémentaires selon ce brevet nécessite :
- une singularisation électrique de chaque module élémentaire du fait du type de connexion par trous métallisés, ce qui a pour conséquence d'utiliser un type de substrat différent par niveau ;
- un perçage de trous suivi d'une métallisation surfacique sur les modules élémentaires et sur les entretoises ;
- après assemblage mécanique, un remplissage de ces trous par un métal fusible.

La réalisation d'un tel module multi-chip a pour inconvénient de nécessiter des opérations coûteuses pour un résultat relativement peu fiable.

Le module multi-puces tridimensionnel de l'invention répond à l'objectif d'intégration maximale de composants électroniques et permet de résoudre les inconvénients cités précédemment.

Dans la suite de la description, on lira indifféremment "module 3D", "module multi-puces 3D" ou encore "module multi-puces tridimensionnel".

De façon plus précise, l'invention a pour objet un module multi-puces, caractérisé en ce qu'il comporte une pluralité de modules électroniques élémentaires bidimensionnels comprenant chacun au moins une puce, un support sur lequel est disposée la puce et un réseau d'interconnexion conducteur recouvrant une surface supérieure du support, lesdits modules élémentaires étant disposés sensiblement les uns sur les autres et connectés les uns aux autres par l'intermédiaire des réseaux d'interconnexion.

Avantageusement, les supports comportent, sur une face inférieure, une cavité de taille sensiblement supérieure à la taille des puces de façon à ce que le support d'un premier module élémentaire puisse être emboîté au-dessus de la puce d'un second module élémentaire.

En outre, chaque module élémentaire comporte au moins un plot de connexion (appelé aussi, plus simplement, plot) disposé sur un bord du support et connecté à la puce par l'intermédiaire du réseau d'interconnexion, chaque plot étant connecté aux plots des modules élémentaires voisins (module supérieur et module inférieur) pour assurer une liaison électrique entre les modules élémentaires.

Selon l'invention, les modules élémentaires disposés sensiblement les uns sur les autres sont décalés les uns par rapport aux autres de façon à ce que les plots de chaque support ne soient pas recouverts par le support du module élémentaire supérieur afin de permettre la connexion de fils électriques dans lesdits plots.

Selon un mode de réalisation de l'invention, chaque module élémentaire comporte une pluralité de puces connectées les unes aux autres par l'intermédiaire du réseau d'interconnexion.

D'autres avantages et particularités de l'invention apparaitront au cours de la description qui va suivre, donnés à titre illustratif, mais non limitatif, en référence aux dessins dans lesquels :
- la figure 1 représente un module multi-puces tridimensionnel à cinq niveaux ;
- la figure 2 représente, de façon schématique, un module multi-puces tridimensionnel à sept niveaux et dans lequel chaque module élémentaire comporte une pluralité de puces ; et
- les figures 3a et 3b représentent, respectivement vu de profil et vu de dessus, un circuit intégré comportant un microprocesseur associé à deux modules multi-puces tridimensionnels.

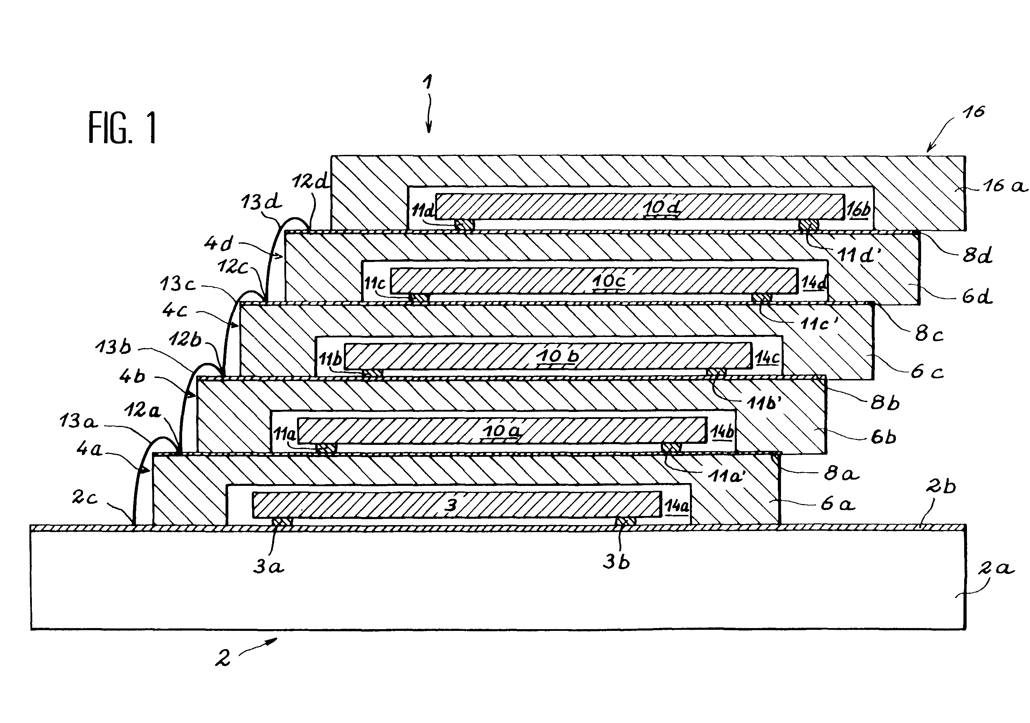

Sur la figure 1, on a représenté un module 1 multi-puces en trois dimensions, que l'on nommera par la suite plus simplement "module 3D". Le module 3D représenté sur cette figure 1 comporte cinq niveaux, c'est-à-dire qu'il comporte quatre modules élémentaires 4a, 4b, 4c, 4d assemblés sur un substrat 2 d'interconnexion, une hybridation de puce 3 disposée sur le substrat 2 et un capot 16 encapsulant le dernier étage de puces, à savoir la puce 10d du module élémentaire 4d.

Selon le mode de réalisation représenté sur cette figure 1, tous les modules élémentaires, à savoir le module 4a, le module 4b, le module 4c et le module 4d sont identiques les uns aux autres. Aussi, afin de simplifier la description, seul le module élémentaire 4a sera décrit de façon détaillée sachant que les modules élémentaires 4b, 4c, 4d sont réalisés identiquement à ce module 4a.

Ce module élémentaire 4a comporte un support 6a dont la surface supérieure est recouverte d'un réseau d'interconnexion 8a. Sur ce réseau d'interconnexion 8a est disposée une puce 10a qui est connectée au réseau d'interconnexion 8a par l'intermédiaire des connexions 11a et 11a'.

Les modules élémentaires 4a, 4b, 4c, 4d sont disposés les uns sur les autres, tels des marches d'escalier, c'est-à-dire que le module 4b, par exemple, est disposé sur le module 4a de façon à être quelque peu décalé par rapport au bord dudit module 4a. Ainsi, la partie du support 6a et la partie du réseau d'interconnexion 8a qui ne sont pas recouvertes par le module élémentaire 4b comportent au moins un plot 12a de connexion. Ainsi, chaque module élémentaire 4a, 4b, 4c, 4d comporte, à sa surface supérieure (c'est-à-dire au niveau de son réseau d'interconnexion respectivement 8a, 8b, 8c, 8d) un plot de connexion respectivement 12a, 12b, 12c, 12d permettant de connecter, grâce à des fils 13a, 13b, 13c, 13d, les différents modules élémentaires les uns aux autres.

Ces plots d'interconnexion sont connectés aux puces par l'intermédiaire du réseau d'interconnexion. Chaque puce peut ainsi être reliée aux puces voisines par l'intermédiaire, d'abord du réseau d'interconnexion, puis des plots de connexion de son module et enfin d'un fil de connexion reliant chaque plot de connexion de son module à un plot de connexion de l'un des modules voisins.

L'utilisation d'un câblage filaire pour l'interconnexion électrique des modules élémentaires entre eux permet, lorsque le besoin existe, d'utiliser des plots relais. Ces plots relais sont disposés sur les portions de modules élémentaires qui ne sont pas recouvertes par d'autres modules élémentaires et ne sont pas connectés au réseau d'interconnexion du support sur lequel ils sont fixés. Dans le cas de modules mémoire 3D, de tels plots relais permettent la singularisation de certaines équipotentielles (telles que chip select ou write enable).

Afin de permettre un meilleur "empilement" des modules élémentaires les uns sur les autres, chaque support 6a, 6b, 6c 6d comporte une cavité respectivement 14a, 14b, 14c, 14d ayant une dimension légèrement supérieure à la dimension de la puce du module inférieur. Par exemple, le module élémentaire 4b comporte une cavité 14b permettant d'empiler ledit module 4b sur le module élémentaire 4a.

En outre, ce module multi-puces tridimensionnel comporte un substrat 2 sur lequel est disposé l'ensemble des modules élémentaires. Ce substrat 2 comporte un support 2a recouvert d'un réseau d'interconnexion 2b de même nature que les réseaux d'interconnexion des modules élémentaires. De même, ce substrat comporte au moins un plot de connexion 2c qui, par l'intermédiaire du fil de connexion 13a, permet une liaison électrique entre ledit substrat 2 et le module élémentaire 4a et, plus précisément, entre le substrat et la puce 10a dudit module 4a.

Sur ce substrat 2, est disposée une puce 3 connectée au réseau d'interconnexion 2c par l'intermédiaire de ses connexions 3a et 3b. Cet ensemble substrat 2/puce 3 constitue ce que l'on a appelé précédemment "l'hybridation de puce sur le substrat".

Ce module multi-puces 3D comporte, en outre, un capot 16 qui permet d'encapsuler le dernier niveau de puces. De façon plus précise, ce capot comporte une partie 16a constituée d'un matériau qui peut être identique à celui des supports 6a, 6b, 6c, 6d ; il comporte également une cavité 16b de dimensions légèrement supérieures à la dimension de la puce 10d qu'il recouvre.

Selon un autre mode de réalisation de l'invention, les cavités 14a, 14b, 14c, 14d des supports des modules élémentaires et la cavité 16b du capot 16 peuvent être remplacées par une entretoise.

Dans le cas de la cavité décrite précédemment, celle-ci est réalisée soit par gravure humide, soit par gravure à sec (c'est-à-dire, par exemple, gravure par plasma) si les supports 6a, 6b, 6c, 6d et le capot 16a sont réalisés en silicium. Si lesdits supports et ledit capot sont réalisés dans un matériau autre que le silicium, le type de gravure sera choisi en fonction de la nature des matériaux utilisés.

Les réseaux d'interconnexion des modules élémentaires et du substrat 2 ne seront pas décrits de façon plus précise car ils sont identiques aux réseaux d'interconnexion des modules multi-puces bidimensionnels. Ils sont donc réalisés par des techniques de dépôt et de gravure de matériaux conducteurs, pour les lignes d'interconnexion, et d'isolants minéraux ou organiques, pour l'enrobage de ces lignes. Aussi, ces réseaux d'interconnexion peuvent être réalisés à partir de matériaux métalliques (pour les lignes d'interconnexion) et par exemple de silice ou de polyimides (pour l'enrobage de ces lignes).

Selon un mode de réalisation de ces réseaux d'interconnexion, la structure desdits réseaux est du type multi-couches, ce qui permet la réalisation de capacités de découplage intégrées entre, par exemple, le corps du module élémentaire qui peut être à la masse et une couche métallique déposée sur une couche mince de diélectrique (SiO2), elle-même déposée sur la face plane supérieure du module.

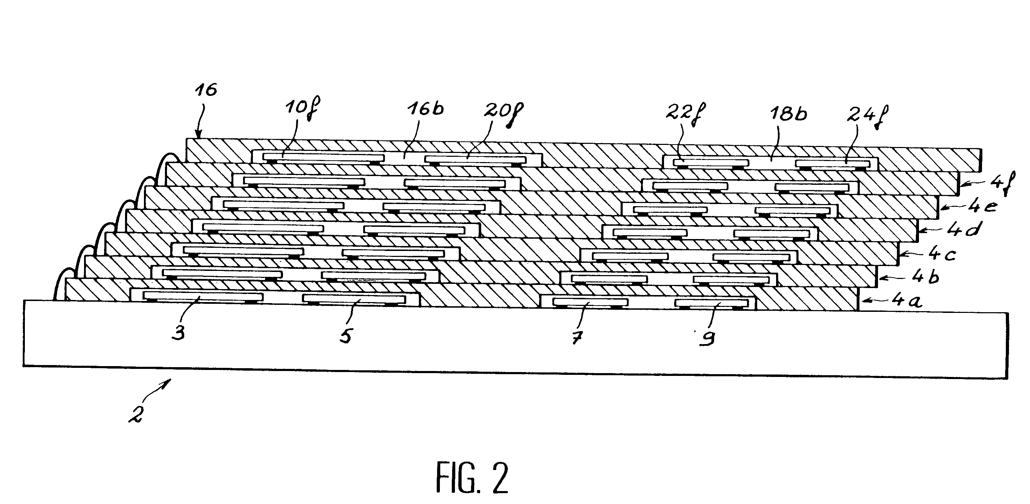

Sur la figure 2, on a représenté un module 3D à sept étages (ou sept niveaux), c'est-à-dire un module 3D comportant six modules élémentaires 4a à 4f et une hybridation de puce 3, 5, 7, 9 sur le substrat 2.

Cette figure 2 comporte des références identiques aux références de la figure 1, chaque référence identique représentant un élément identique. Par exemple, le module 3D représenté sur cette figure 2 comprend les modules élémentaires 4a, 4b, 4c, 4d, déjà montrés sur la figure 1 et des modules élémentaires 4e et 4f représentant les deux étages supplémentaires par rapport au module 3D représenté sur la figure 1.

En outre, sur cette figure 2, chaque module élémentaire comporte quatre puces référencées 10f, 10f, 22f, 24f pour les puces du modules élémentaires 4f. Afin de permettre l'empilage des différents modules élémentaires les uns sur les autres, chaque support de module élémentaire comporte une pluralité de cavités, référencées 16b et 18b pour les cavités réalisées dans le capot 16.

Selon un autre mode de réalisation de l'invention, les supports et le capot ne comporte chacun qu'une grande cavité dans laquelle toutes les puces du module élémentaire inférieur peuvent être introduites.

Chaque module élémentaire n'est pas décrit de façon plus précise sur cette figure car chacun desdits modules est réalisé de façon identique au module 4f décrit.

On comprendra, bien évidemment, que si la figure 2 a été représentée pour des modules élémentaires comprenant quatre puces sur un côté (soit 16 puces si le module élémentaire est carré), ces modules élémentaires formant le module 3D peuvent, pour d'autres modes de réalisation, comporter quatre, neuf ou n puces (n étant un nombre entier).

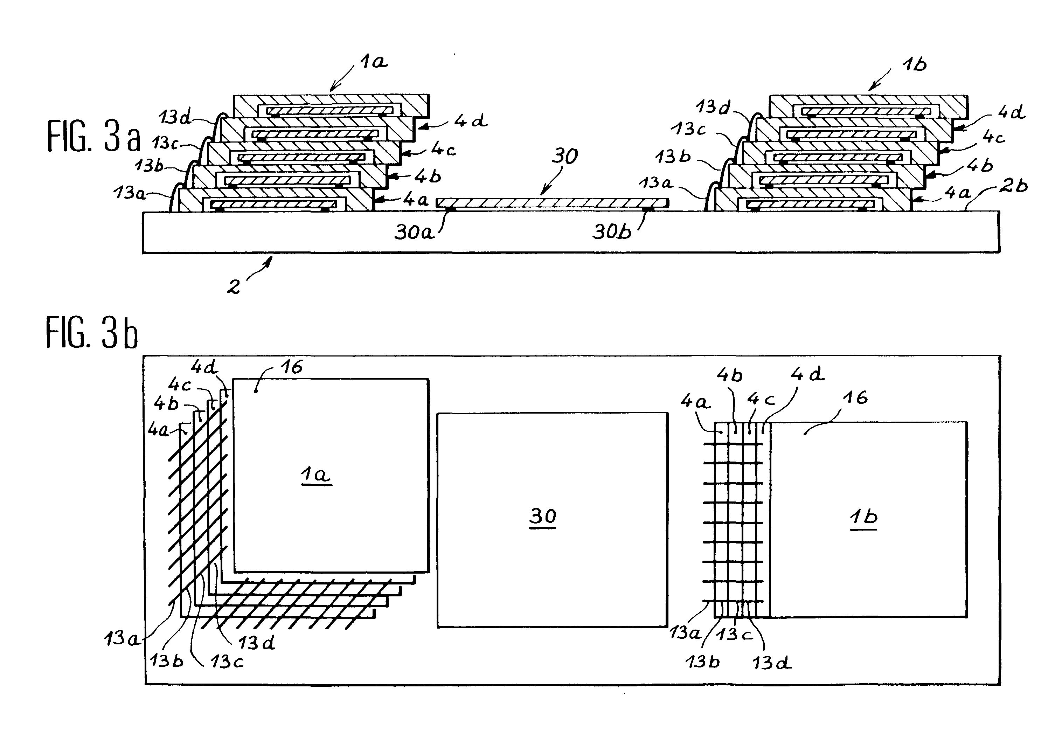

Sur les figures 3a et 3b, on a représenté un circuit intégré comportant un microprocesseur associé à deux modules multi-puces 3D. Selon un exemple d'application de ce circuit intégré, les modules multi-puces 3D peuvent être des modules mémoire 3D.

La figure 3 représente ce circuit intégré, vu de profil, et la figure 3b le représente vu de dessus.

Sur la figure 3a, on peut donc voir deux modules 3D de même type que le module 1 représenté sur la figure 1. Ces deux modules sont référencés 1a et 1b. Sur cette figure 3a est également représenté le microprocesseur 30 qui est associé aux modules multi-puces tridimensionnels 1a et 1b. En effet, ce microprocesseur 30 est connecté sur le réseau d'interconnexion 2b du substrat 2 par l'intermédiaire de connexions 30a et 30b. Ce réseau d'interconnexion 2b permet donc de relier électriquement les puces du module la et les puces du module 1b à ce microprocesseur 30.

Dans ce mode de réalisation, les modules 3D, la et 1b sont, comme cités précédemment, des modules de mémoire. Bien entendu, ces modules 1a et 1b peuvent être des modules autres que des modules de mémoire.

Cette figure 3a ne sera pas décrite de façon plus détaillée car la description des modules 3D qui y sont représentés a déjà été réalisée lors de la description de la figure 1 et le microprocesseur 30 peut être considéré comme un module bidimensionnel connecté sur le substrat 2.

La figure 3b représente le même mode de réalisation que la figure 3a, mais selon une vue de dessus. Ainsi, sur cette figure 3b, on remarque que le module multi-puces tridimensionnel la comporte un décalage dans deux directions, c'est-à-dire que chaque module élémentaire est décalé, par rapport au module élémentaire inférieur, sur deux côtés dudit module. D'autre part, le module multi-puces tridimensionnel 1b ne comporte, quant à lui, un décalage suivant une seule direction.

De façon plus précise, on voit sur cette figure 3b, le capot 16 du module multi-puces tridimensionnel 1a, les bordures contenant les plots de connexion des modules élémentaires 4d, 4c, 4b, 4a. On voit également les fils de connexion 13a, 13b, 13c, 13d permettant de connecter, respectivement, les puces des modules élémentaires 4a et le substrat 2, les puces du module élémentaire 4a avec les puces du module élémentaire 4b, les puces du module élémentaire 4b avec les puces du module élémentaire 4c, et les puces du module élémentaire 4c avec les puces du module élémentaire 4d. On comprendra, bien sûr, qu'il y a autant de fils de connexion entre deux modules élémentaires qu'il y a de plots de connexion sur les modules.

Cette vue de dessus du module multi-puces 3D permet de montrer le décalage selon deux directions de chaque module élémentaire par rapport au module élémentaire inférieur. Cette figure permet donc de comprendre avec aisance que, lorsqu'un tel module multi-puces tridimensionnel comporte un décalage selon deux directions, le nombre de plots de connexion entre les modules élémentaires peut être le double du nombre de plots de connexion d'un module multi-puces 3D comportant un seul décalage, tel que celui référencé 1b sur cette même figure.

on comprendra aisément que si l'on a représenté sur les figures 1, 2, 3a et 3b une hybridation de puce(s) sur le substrat, il est possible, dans un mode de réalisation plus simple, de n'utiliser qu'un substrat sur lequel repose un ensemble de modules élémentaires.

Ces modules élémentaires, quelque soit le mode de réalisation de l'invention (avec une hybridation, ou avec un simple substrat) sont assemblés par collage ou par brassage les uns sur les autres. Il en est de même pour le capot 16 qui est assemblé au dernier module élémentaire par une méthode identique à l'assemblage desdits modules élémentaires.

Ces modules multi-puces tridimensionnels sont donc réalisés à partir de procédés simples à mettre en oeuvre, puisque les technologies utilisées sont des technologies déjà connues et utilisées, notamment pour les modules bidimensionnels.

Les supports, capots et substrats peuvent être réalisés dans des matériaux identiques ou différents. Le choix d'un matériau comme le silicium offre la possibilité pour ces éléments d'être eux-mêmes constitués ou non d'un semi-conducteur selon le dopage.

Lorsque les supports et capots sont en silicium, il est avantageux de réaliser le substrat en silicium afin d'éviter, d'une manière simple, les problèmes issus de la dilatation de ces différents éléments.

En outre, le silicium a la particularité d'être assez bon conducteur électrique lorsqu'il est fortement dopé. L'utilisation du silicium dopé pour la réalisation des modules élémentaires et du substrat permet de disposer des plans équipotentiels (par exemple, un plan de masse) au sein du dispositif.

L'utilisation du silicium pour la réalisation des modules élémentaires et du substrat et la particularité de la gravure chimique anisotrope de ce matériau permettant, de plus, de réaliser des cavités en pente suivant des plans cristallographiques et selon des côtes très précises, ce qui assure un auto-alignement des modules élémentaires sur les puces montées par flip-chip lors de l'assemblage.

Selon l'invention, chaque module élémentaire du module 3D peut être testé de façon indépendante. Aussi, chacune de ces puces peut être réparée séparément des autres puces du module 3D.

En outre, le nombre de modules élémentaires assemblables est variable en fonction des besoins et il est possible d'interconnecter différents types de puces entre elles. Aussi, il est possible de réaliser un système entièrement intégré dans un module 3D.

## Revendications

1. Module multi-puces comportant un substrat (2) et une pluralité de modules électroniques élémentaires bidimensionnels (4a-4d) comprenant chacun au moins une puce (10a-10d) et un support (6a-6d) sur lequel est disposée la puce, les modules élémentaires étant disposés sensiblement les uns sur les autres et déposés sur le substrat, **caractérisé en ce que** le substrat et les supports de modules élémentaires comportent chacun une face supérieure recouverte d'un réseau d'interconnexion et **en ce que** les modules élémentaires disposés sensiblement les uns sur les autres sont décalés les uns par rapport aux autres et par rapport au substrat de façon à ce qu'une portion de chaque réseau d'interconnexion ne soit pas recouverte par le support d'un module élémentaire supérieur afin de permettre la connexion des réseaux d'interconnexion entre eux par des fils électriques.

2. Module multi-puces selon la revendication 1, **caractérisé en ce que** les supports comportent, sur une face inférieure, une cavité (14a-14d) de taille sensiblement supérieure à la taille des puces de façon à ce que le support d'un premier module élémentaire puisse être disposé au-dessus de la puce d'un second module élémentaire.

3. Module multi-puces selon la revendication 1 ou 2, **caractérisé en ce que** chaque module élémentaire comporte au moins un plot de connexion (12a-12d) disposé sur un bord du support et connecté à la puce par l'intermédiaire du réseau d'interconnexion, chaque plot de connexion étant connecté aux plots de connexion des modules élémentaires supérieur et inférieur pour assurer une liaison électrique entre lesdits modules élémentaires.

4. Module multi-puces selon l'une quelconque des revendications 1 à 3, **caractérisé en ce que** chaque module élémentaire comporte une pluralité de puces connectées les unes aux autres par l'intermédiaire du réseau d'interconnexion.

## Patentansprüche

1. Multichip-Modul mit einem Substrat (2) und einer Vielzahl zweidimensionaler elektronischer Elementarmodule (4a-4d), von denen jeder wenigstens einen Chip (10a-10d) und einen Träger (6a-6d) umfasst, auf dem der Chip angeordnet ist, wobei die Elementarmodule im Wesentlichen aufeinander angeordnet und auf dem Substrat abgeschieden sind,
**dadurch gekennzeichnet,**
**dass** das Substrat und die Träger der Elementarmodule jeweils eine Oberseite umfassen, die mit einem Zwischenverbindungsgitter überzogen ist, und dadurch, dass die im Wesentlichen übereinander angeordneten Elementarmodule zueinander und in Bezug auf das Substrat versetzt sind, so dass ein Teil jedes Zwischenverbindungsgitters nicht durch den Träger eines höheren Elementarmoduls abgedeckt wird und die Verbindung der Zwischenverbindungsgitter untereinander durch elektrische Drähte möglich ist.

2. Multichip-Modul nach Anspruch 1, **dadurch gekennzeichnet, dass** die Träger auf einer Unterseite einen Hohlraum (14a-14d) aufweisen, der wesentlich größer ist als die Größe der Chips, so dass der Träger eines ersten Elementarmoduls über dem Chip eines zweiten Elementarmoduls angeordnet werden kann.

3. Multichip-Modul nach Anspruch 1 oder 2, **dadurch gekennzeichnet, dass** jeder Elementarmodul wenigstens eine Verbindungskontakteinrichtung (12a-12d) umfasst, angeordnet auf einem Rand des Trägers und mit dem Chip durch das Zwischenverbindungsgitter verbunden, wobei jede Verbindungskontakteinrichtung mit den Verbindungskontakteinrichtungen der höheren und tieferen Elementarmodule verbunden ist, um eine elektrische Verbindung zwischen den genannten Elementarmodulen herzustellen.

4. Multichip-Modul nach einem der Ansprüche 1 bis 3, **dadurch gekennzeichnet, dass** jeder Elementarmodul eine Vielzahl von Chips umfasst, die durch das Zwischenverbindungsgitter miteinander verbunden sind.

## Claims

1. Multichip module having a substrate (2) and plurality of bidimensional, elementary electronic modules (4a-4d), each having at least one chip (10-10d) and a support (6a-6d) on which is placed the chip, the elementary modules being substantially superimposed and deposited on the substrate, **characterized in that** the substrate and the supports of the elementary modules have in each case an upper face covered by an interconnection network and **in that** the elementary modules which are substantially superimposed are displaced with respect to one another and with respect to the substrate in such a way that a portion of each interconnection network is not covered by the support of an upper elementary module, so as to permit the interconnection of the interconnection networks by electric wires.

2. Multichip module according to claim 1, **characterized in that**, on a lower face, the supports have a cavity (14a-14d) with a size significantly greater than that of the chips, so that the support of a first elementary module can be placed above the chip of a second elementary module.

3. Multichip module according to claim 1 or 2, **characterized in that** each elementary module has at least one connecting pad (12a-12d) placed on one edge of the support and connected to the chip by means of the interconnection network, each connecting pad being connected to the connecting pads of the upper and lower elementary modules in order to ensure an electrical connection between said elementary modules.

4. Multichip module according to any one of the claims 1 to 3, **characterized in that** each elementary module has a plurality of chips connected to one another by means of the interconnection network.
